Europäisches Patentamt

European Patent Office

Office européen des brevets

(11) Publication number: **0 265 680**
**A1**

## (12) EUROPEAN PATENT APPLICATION

(21) Application number: 87114142.0

(22) Date of filing: 28.09.87

(51) Int. Cl.4 **H03F 3/30**

(30) Priority: 30.09.86 US 913208

(43) Date of publication of application:
**04.05.88 Bulletin 88/18**

(84) Designated Contracting States:
**DE FR GB NL**

(71) Applicant: **TEKTRONIX, INC.**
**Tektronix Industrial Park D/S Y3-121 4900**
**S.W. Griffith Drive P.O. Box 500**
**Beaverton Oregon 97077(US)**

(72) Inventor: **Taylor, Steward S.**
**16927 N.W. Hazelgrove Court**
**Beaverton Oregon 97006(US)**

(74) Representative: **Baillie, Iain Cameron et al**
**c/o Ladas & Parry Isartorplatz 5**
**D-8000 München 2(DE)**

(54) **Wide bandwidth low distortion class b amplifier.**

(57) A class B amplifier (10) employs output transistors (48 and 50) of the same polarity to drive a load impedance (52). The voltage gain from the input ($V_I$) to the output ($V_o$) of the amplifier is substantially the same for both positive and negative voltage excursions of the input signal. The amplifier has a generally symmetric DC transfer characteristic and relatively wide bandwidth. A preferred embodiment of the amplifier is implemented in a design that eliminates the diode positioned between the NPN transistors of a class B amplifier of the totem pole type.

F I G. I

EP 0 265 680 A1

Xerox Copy Centre

0 265 680

## WIDE BANDWIDTH, LOW DISTORTION CLASS B AMPLIFIER

### Background of the Invention

The present invention relates to class B power amplifiers and, in particular, to a class B amplifier that employs only NPN output transistors of wide bandwidth and of large current capacity and provides substantially the same voltage gain from the input to the output of the amplifier for both positive and negative excursions of an applied input signal.

A class B or "push-pull" amplifier is desirable as an output stage because it dissipates a very small or zero amount of electrical power in the absence of an input signal. In a class B transistor amplifier, two transistor devices alternately deliver electrical power to a load impedance, one transistor conducting electrical current in response to the positive excursion and the other transistor conducting electrical current in response to the negative excursion of an input signal. One type of class B transistor amplifier, known as a complementary output stage, uses a PNP transistor and an NPN transistor to drive a load impedance. The performance of a complementary output stage implemented in an integrated circuit is generally unacceptable for high-speed applications because the bandwidth of a PNP transistor is typically significantly lower than that of an NPN transistor.

Another type of class B transistor amplifier, known as a totem pole amplifier, uses two NPN transistors to deliver electrical power to a load impedance. In a totem pole amplifier, one of the transistors functions as an emitter-follower, and the other transistor functions as a common-emitter amplifier. The input signal is applied between the base and the emitter terminals of the common-emitter transistor. A diode is positioned between the emitter terminal of the emitter-follower transistor and the collector terminal of the common-emitter transistor. The load impedance is connected to the emitter terminal of the emitter-follower and the anode terminal of the diode. The emitter-follower transistor and the common-emitter amplifier deliver power to the load impedance in response to, respectively, the negative excursion and the positive excursion of an input signal. The disadvantage of the totem pole class B amplifier is that its voltage transfer characteristic is nonlinear. The reason is that the signal path from the input of the amplifier to the load impedance includes the emitter-follower for positive excursions of the input signal, but such signal path does not include the emitter-follower for negative excursions of the input signal.

### Summary of the Invention

An object of the invention is, therefore, to provide a wide band class B amplifier that is capable of delivering large amounts of current to a load impedance.

Another object of this invention is to provide such an amplifier whose transfer characteristic is linear for both the positive and negative excursions of the input signal.

Still another object of this invention is to provide such an amplifier whose gain is substantially the same for both the positive and negative excursions of the input signal.

Yet another object of this invention is to provide such an amplifier that uses only NPN transistors to drive the load impedance.

The present invention is a class B amplifier that employs output transistors of the same polarity, i.e., transistors of noncomplementary types, to drive a load impedance. The voltage gain from the input to the output of the amplifier is substantially the same for both positive and negative voltage excursions of the input signal. This provides an amplifier with a generally symmetric DC transfer characteristic and relatively wide bandwidth. The amplifier is also easier to compensate than other class B amplifier designs. A preferred embodiment of the amplifier of the present invention is implemented in a design that eliminates the diode positioned between the NPN transistors of a totem pole amplifier.

Additional objects and advantages of the present invention will be apparent from the following detailed description of a preferred embodiment thereof, which proceeds with reference to the accompanying drawing.

### Brief Description of the Drawing

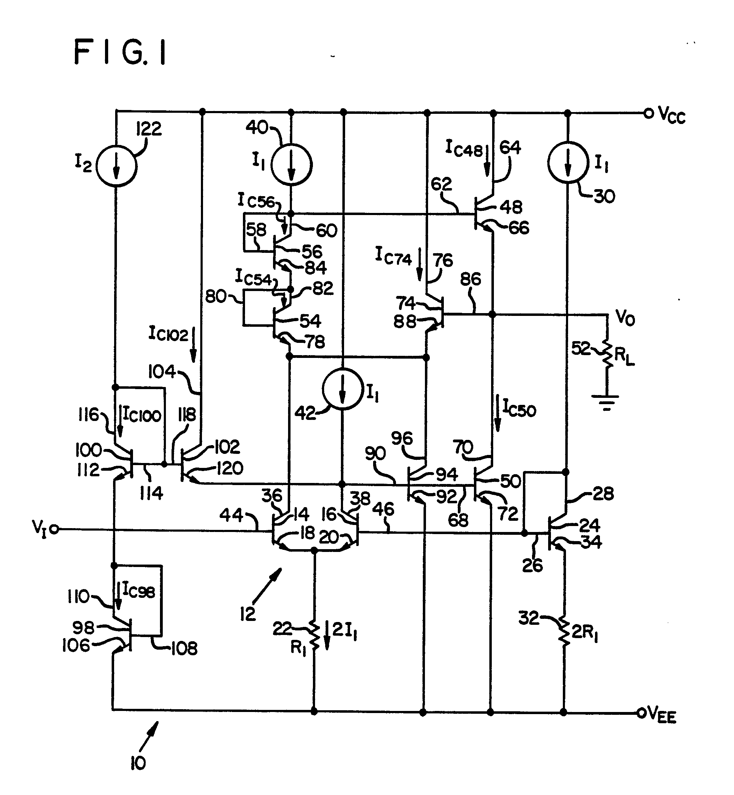

Fig. 1 is an electrical schematic diagram of the class B amplifier circuit of the present invention.

2

## Detailed Description of Preferred Embodiment

Fig. 1 is an electrical circuit diagram of a preferred embodiment of a class B amplifier 10 that uses a differential amplifier 12 configured in the single-ended input mode. Differential amplifier 12 includes NPN transistors 14 and 16 whose respective emitter terminals 18 and 20 are electrically connected to one of the leads of a resistor 22 of resistance value "$R_1$." The other lead of resistor 22 is connected to the emitter bias voltage supply, $V_{EE}$. The resistance value, $R_1$, of resistor 22 is usually large compared with those of the emitters of transistors 14 and 16 so that resistor 22 establishes the proper bias current. A diode-connected transistor 24, whose base terminal 26 is connected to its collector terminal 28, cooperates with a constant-current source 30. Constant-current source 30 provides a current of value "$I_1$" that flows through a resistor 32 of resistance value "$2R_1$," which is connected to emitter terminal 34 of transistor 24. The current flowing through resistor 32 establishes from base terminal 26 of transistor 24 to $V_{EE}$ a bias voltage which develops a current of value "$2I_1$" in resistor 22 of value "$R_1$." A current of value "$I_1$" flows from the collector terminal 36 to the emitter terminal 18 of transistor 14 and from the collector terminal 38 to the emitter terminal 20 of transistor 16. Constant-current sources 40 and 42 provide the currents of value "$I_1$" that equals the collector currents of transistors 14 and 16. Constant-current sources 40 and 42 are connected to the collector bias voltage supply, $V_{CC}$ and can be of the conventional PNP transistor type. The base terminal 44 of transistor 14 receives a bipolar voltage input signal, $V_i$, and base terminal 46 of transistor 16 is connected to base terminal 26 and collector terminal 28 of diode-connected transistor 24.

Transistors 14 and 16 develop in response to the polarity of the input signal respective first and second drive signals that are delivered through other electrical components to output NPN transistors 48 and 50, which are configured in a push-pull drive arrangement to conduct electrical current flowing through a load resistor 52. (An impedance element having a reactive component could be substituted for load resistor 52.) The output voltage, $V_o$, of amplifier 10 appears across resistor 52, which has a resistance value "$R_L$."

Whenever a portion of the input signal $V_i$ is of increasing negative polarity, transistor 14 conducts a decreasing amount of current from its collector terminal 36 to its emitter terminal 18. Since the current flowing through resistor 22 is approximately constant, a decrease in the amount of current flowing through emitter terminal 18 of transistor 14 causes a corresponding increase in the amount of current flowing through emitter 20 of transistor 16 and, therefore, through collector 38 of transistor 16. The current flowing through collector 36 of transistor 14 also flows through diode-connected transistors 54 and 56, which are connected in series. The base terminal 58 and the collector terminal 60 of transistor 56 are connected to the base terminal 62 of output transistor 48. The reduction in current flowing through transistor 14 during the negative polarity portion of $V_i$ causes additional current to flow into base terminal 62 of transistor 48 and thereby causes additional current to flow from collector terminal 64 to emitter terminal 66 of transistor 48. During the negative portion of input signal $V_i$, current flows into load resistor 52, thereby producing positive output voltage signal $V_o$. The electrical signal path for positive output voltage signals begins at base terminal 44 of transistor 14 and continues to collector terminal 36 of transistor 14, to diode-connected transistors 54 and 56, to base terminal 62 of output transistor 48, to emitter terminal 66 of output transistor 48, and ends at load resistor 52. The current flowing through collector terminal 38 of transistor 16 also increases as the current flowing through collector terminal 36 of transistor 14 decreases. This causes the current flowing through base terminal 68 and, therefore, the current flowing through collector terminal 70 of output transistor 50 to decrease.

The voltage gain, $A_v = V_o/V_i$, for signals flowing through the above-described signal path for negative input voltages equals approximately $(1/2) \times (g_m \times \beta \times R_L)$, where $g_m$ and $\beta$ are the transconductance of transistor 14 and the current gain of output transistor 48, respectively. The above expression for $A_v$ is premised on the assumptions that the input impedance of transistor 48 equals $\beta \times R_L$ and that the output impedances of constant-current source 40 and transistor 14 are much greater than $\beta \times R_L$.

Whenever a portion of the input signal $V_i$ is of increasing positive polarity, transistor 14 conducts an increasing amount of current from its collector terminal 36 to its emitter terminal 18. This causes a corresponding decrease in the amount of current flowing through emitter terminal 20 of transistor 16. Collector terminal 38 of transistor 16 is connected to the base terminal 68 of output transistor 50. The reduction in current flowing through transistor 16 during the positive polarity portion of $V_i$ causes additional current to flow into base terminal 68 of transistor 50 and thereby causes additional current to flow into collector terminal 70 and continue to emitter terminal 72 of transistor 50. During the positive portion of input signal $V_i$, current flows out of load resistor 52, thereby producing a negative output voltage signal $V_o$. The electrical signal path for negative output voltage signals begins at base terminal 44 of transistor 14 and continues to emitter terminal 18 of transistor 14, to emitter terminal 20 of transistor 16, to collector terminal 38 of transistor 16, to base terminal 68 of output transistor 50, to collector terminal 70 of output transistor 50, and ends at load resistor 52. The current flowing through collector terminal 36 of transistor 14 also increases as the current flowing through collector terminal 38 of transistor 16 decreases. This causes the current flowing through base terminal 62 and, therefore, the current flowing through collector terminal 64 of transistor 48 to decrease.

The voltage gain, $A_v = V_o/V_i$, for signals flowing through the above-described signal path for positive input voltages equals approximately $(1/2) \times (g_m \times \beta \times R_L)$, where $g_m$ and $\beta$ are the transconductance of transistor 16 and the current gain of output transistor 50, respectively. It is apparent, therefore, that the voltage gains for both positive and negative excursions of the input signal $V_i$ are approximately the same under the above-stated conditions whenever the $\beta$ values of transistors 48 and 50 are equal and the $g_m$ values of transistors 14 and 16 are equal.

Amplifier 10 employs first and second bias loops, the first bias loop setting the quiescent operating point of output transistors 48 and 50 and providing class AB operation and the second bias loop clamping base terminal 68 of transistor 50 and collector terminal 38 of transistor 16 to reduce the recovery time and to prevent saturation of transistor 16 and cutoff of transistor 50. Amplifier 10 operates, however, predominantly as a class B amplifier and is herein referred to as such. The biasing of amplifier 10 is accomplished in the manner described below.

The first bias loop in amplifier 10 includes the pair of diode-connected transistors 54 and 56, output transistor 48, and an NPN transistor 74 having its collector terminal 76 connected to $V_{CC}$. The first bias loop defines a signal path that begins at emitter terminal 78 of transistor 54 and continues to the electrically common base terminal 80 and collector terminal 82 of transistor 54, to emitter terminal 84 of transistor 56, to the electrically common base terminal 58 and collector terminal 60 of transistor 56, to base terminal 62 and emitter terminal 66 of output transistor 48, to base terminal 86 and emitter terminal 88 of transistor 74, and ends at emitter terminal 78 of transistor 54. The following expression follows from Kirchoff's voltage law for the first bias loop and uses the Ebers-Moll equation for each of the base-to-emitter voltages of transistors 54, 56, 48, and 74:

$$(I_{c54}/I_{s54}) \times (I_{c56}/I_{s56}) = (I_{c48}/I_{s48}) \times (I_{c74}/I_{s74}),$$

where $I_{c54}$, $I_{c56}$, $I_{c48}$, and $I_{c74}$ represent the collector currents of transistors 54, 56, 48, and 74, respectively, and where $I_{s54}$, $I_{s56}$, $I_{s48}$, and $I_{s74}$ represent the saturation currents of the base-emitter junctions of transistors 54, 56, 48, and 74, respectively.

Base terminal 68 and emitter terminal 72 of transistor 50 are connected to, respectively, the base terminal 90 and the emitter terminal 92 of an NPN transistor 94. Collector terminal 96 of transistor 94 is connected to emitter terminal 88 of transistor 74. Transistor 94 is of a design that delivers from its collector terminal 96 a current which is a scaled version (usually smaller) of the current flowing through collector terminal 70 of output transistor 50. The scaled version of the current flowing through collector terminal 70 of transistor 50 also flows through emitter terminal 88 of transistor 74. The base-to-emitter voltage of transistor 74 provides, therefore, a scaled replica of the base-to-emitter voltage of transistor 50 for the first bias loop, which controls the class AB action of amplifier 10. For the reasons set forth below, transistors 74 and 94 are chosen to have emitter areas that are proportional to that of transistor 50. Under these conditions, $I_{c74} = I_{c50}/K$, where $I_{c50}$ represents the quiescent collector current of transistor 50 and K is a constant of proportionality. In addition, whenever $V_o = 0$ volts, $I_{c48} = I_{c50}$ and $I_{c54} = I_{c56} = I_1$. Substituting these equalities into the above equation for the first bias loop gives the following expression for $I_{c48}$ and $I_{c50}$:

$$I_{c48} = I_{c50} = I_1 \sqrt{K \times (I_{s48} \times I_{s74})/(I_{s54} \times I_{s56})}.$$

The following expression characterizes amplifier 10 for all operating conditions and without regard to the function of the below-described second bias loop:

$I_{c48} \times I_{c50}$ = constant
$= K \times I_1^2 \times (I_{s48} \times I_{s74})/(I_{s54} \times I_{s56})$.

The above equation indicates that as $I_{c48}$ increases (i.e., there is a positive output voltage $V_o$ ), $I_{c50}$ must decrease. Similarly, as $I_{c50}$ increases (i.e., there is a negative output voltage $V_o$ ), $I_{c48}$ must decrease. This demonstrates that amplifier 10 provides the desired class AB function.

The second bias loop in amplifier 10 includes a pair of diode-connected NPN transistors 98 and 100, an NPN emitter-follower transistor 102 having its collector terminal 104 connected to $V_{CC}$, and output transistor 50. The second bias loop defines a signal path that begins at emitter terminal 106 of transistor 98 and continues to the electrically common base terminal 108 and collector terminal 110 of transistor 98, to emitter terminal 112 of transistor 100, to the electrically common base terminal 114 and collector terminal 116 of transistor 100 to base terminal 118 and emitter terminal 120 of transistor 102, to base terminal 68 and emitter terminal 72 of transistor 50, and ends at emitter terminal 106 of transistor 98. The following expression follows from Kirchoff's voltage law for the second bias loop and uses the Ebers-Moll equation for each of the base-to-emitter voltages of transistors 98, 100, 102, and 50:

$$(I_{c98}/I_{s98}) \times (I_{c100}/I_{s100}) = (I_{c102}/I_{s102}) \times (I_{c50}/I_{s50}),$$

where $I_{c98}$, $I_{c100}$, and $I_{c102}$, and $I_{c50}$ represent the collector currents of transistors 98, 100, 102, and 50, respectively, and where $I_{s98}$, $I_{s100}$, $I_{s102}$ and $I_{s50}$ represent the saturation currents of the base-emitter junctions of transistors 98, 100, 102, and 50, respectively.

The currents $I_{c98}$ and $I_{c100}$ are equal to $I_2$, the value of a constant-current source 122 which is connected to collector 116 of transistor 100. Substituting $I_2$ for $I_{c98}$ and $I_{c100}$ into the above equation for the second bias loop gives the following expression for $I_{c102}$:

$$I_{c102} = (I_2^2/I_{c50}) \times (I_{s50} \times I_{s102})/(I_{s98} \times I_{s100}).$$

Whenever $V_o$ is 0 volts or is a negative voltage, the current $I_{c102}$ is chosen by design to be relatively small (e.g., less than 1.0 microampere) so that transistor 102 does not diminish the gain for the signal path through transistors 16 and 50. This is accomplished by choosing appropriate values for $I_2$, $I_{s98}$, $I_{s100}$, and $I_{s102}$, given a value for $I_{s50}$. Whenever $V_o$ is a positive voltage, transistor 102 delivers an increased amount of current from its emitter terminal 120 to base terminal 68 of transistor 50, thereby acting as a clamp to prevent transistor 16 from saturating and transistor 50 from cutting off. Transistor 102 promotes, therefore, a relatively short recovery time for transistor 50 when it again begins to conduct after the output voltage $V_o$ has been positive. To ensure the performance described above, the value for $I_2$ is at least 5-10 times greater than $I_1/\beta$.

Transistor 94 is constructed with the same area as that of transistor 74 and provides a collector current that replicates a scaled version of the current flowing through collector terminal 70 of output transistor 50. Transistors 94 and 74 draw less current than does transistor 50, thereby saving power but developing a scaled replica of the base-to-emitter voltage of transistor 50. This voltage is required by the first bias loop to establish the desired class AB action.

An alternative embodiment would substitute a diode-connected transistor for transistors 74 and 94. The base and collector terminals of the diode-connected transistor would be connected to emitter terminal 66 of output transistor 48 ( i.e., $V_o$), and the emitter terminal of the diode-connected transistor would be connected to collector terminal 70 of transistor 50. This embodiment may adversely affect circuit performance if the collector resistance of the diode-connected transistor is relatively large. Such resistance would cause a relatively large voltage drop for large output currents and thereby cause the diode-connected transistor to saturate.

It will be obvious to those having skill in the art that many changes may be made in the above-described details of the preferred embodiment of the present invention without departing from the underlying principles thereof. For example, amplifier 10 could be implemented in circuitry having field effect transistor (FET) devices of the same polarity, i.e. , JFET devices or MOSFET devices. In an amplifier circuit incorporating FET devices, a source follower would replace the emitter follower output transistor and a common source output transistor would replace the common emitter output transistor. The FET output devices would be either both N-channel devices or both P-channel devices.

## Claims

1. A wide bandwidth, low distortion class B amplifier, comprising:

input transistor means receiving an input signal having a positive polarity portion and a negative polarity portion for producing a first drive signal in response to the positive polarity portion and a second drive signal in response to the negative polarity portion;

first and second transistors of the same polarity that conduct electrical current flowing through a load

5

impedance in response to the input signal, the first transistor conducting the electrical current in response to the positive polarity portion of the input signal and the second transistor conducting the electrical current in response to the negative polarity portion of the input signal; and

electrical conducting means for providing a first electrical signal path for the first drive signal to drive the first transistor and a second electrical signal path for the second drive signal to drive the second transistor, the first and second electrical signal paths providing substantially the same gain from the input transistor means to the load impedance.

2. The amplifier of claim 2 in which the load impedance has a value, $Z_L$, and each of the first and second transistors is of the NPN type and has a current gain, $\beta$ , and in which the gain is a voltage gain, $A_V$, that equals $(1/2) \times (g_m \times \beta \times Z_L)$, where $g_m$ represents the transconductance value of the amplifier.

3. The amplifier of claim 2 in which the load impedance is a resistor of resistance value, $R_L$, and the voltage gain, $A_V$, equals $(1/2) \times (g_m \times \beta \times R_L)$.

4. The amplifier of claim 1 in which the input transistor means comprises a differential amplifier that is configured in the differential input mode and has differential input terminals to which the input signal is applied.

5. The amplifier of claim 1 in which the input transistor means comprises a differential amplifier that is configured in the single-ended input mode and has an input terminal to which the input signal is applied.

6. The amplifier of claim 1 in which the first and second transistors are of the bipolar type and in which one of the first and second transistors is an emitter-follower whose emitter terminal is in direct electrical connection to the load impedance, and the other one of the first and second transistors is a common emitter amplifier whose collector terminal is in direct electrical connection to the load impedance.

7. The amplifier of claim 1 which further comprises first bias voltage loop means for providing substantially class B operation of the amplifier, the first bias voltage loop means including a voltage that is a replica of the base-to-emitter voltage of the one of the first and second transistors that conducts the electrical current flowing through the load impedance as a negative voltage is developed across it.

8. The amplifier of claim 7 which further comprises second bias voltage loop means for preventing cutoff of the one of the first and second transistors that conducts the electrical current flowing through the load impedance as a negative voltage is developed across it.

9. The amplifier of claim 1 which further comprises second bias voltage loop means for preventing cutoff of the one of the first and second transistors that conducts the electrical current flowing through the load impedance as a negative voltage is developed across it.

FIG. 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | DE-A-3 015 889 (HITACHI)<br>* figure 1, page 10, lines 20-31 * | 1,6 | H 03 F   3/30 |
| A | * figure 3 * | 4,5 | |
| Y | US-A-4 050 029 (R:J. Mc FAYDEN)<br>* figure 2, column 8, lines 38-55,<br>column 4, lines 21-61 * | 1,6 | |
| A | US-A-3 938 053 (P. MENNITI et al.)<br>* figure 2, column 1, line 54 - column<br>2, line 16 * | 1,6 | |
| A | US-A-3 868 580 (C.R. BATTJES)<br>* figure 1, abstract * | | |

**TECHNICAL FIELDS SEARCHED (Int. Cl.4)**

H 03 F   3/213
H 03 F   3/30

The present search report has been drawn up for all claims

| Place of search | Date of completion of the search | Examiner |
|---|---|---|
| BERLIN | 06-01-1988 | BREUSING J |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)